# EUROPEAN PATENT SPECIFICATION

(11) **EP 3 821 574 B1**
(45) Date of publication and mention of the grant of the patent: **14.06.2023**
(21) Application number: 19736393.0
(22) Date of filing: 09.07.2019
(51) Int. Cl.: H04L 25/02, G08C 19/00, H03K 3/00, H03K 4/50, H03K 19/0185

(54) **DIGITAL ISOLATOR**
DIGITALER ISOLATOR
ISOLATEUR NUMÉRIQUE

(30) Priority: 10.07.2018 EP 18182754
(43) Date of publication of application: 19.05.2021
(73) Proprietor: Vddtech, 1435 Mont-Saint-Guibert (BE)
(72) Inventor: DESSARD, Vincent, 1435 Mont-Saint-Guibert (BE)
(74) Representative: Debled, Thierry
(86) International application number: PCT/EP2019/068444
(87) International publication number: WO 2020/011801

(56) References cited:
- US-A- 6 144 326
- US-A1- 2012 161 841
- US-A1- 2016 126 724

## Description

### Field of the invention

The present invention generally relates to the field of capacitive isolation links.

The invention relates to the field of capacitive isolation systems for use in isolating electrical circuits from one another while transmitting digital information data. More particularly, this invention relates to isolation systems having capacitor-coupled isolation barriers. This is useful in, for example, industrial process control application, telephony, medical electronics, data communication.

### Description of prior art

Isolators are generally implemented to separate circuits or circuit sections of the electrical circuit to one another from undesired influence of, as for example but not limiting, other circuits or circuit sections, to minimize the influence of common mode transients (CMT), influence of radiation or electromagnetic interferences, cross talk, between circuits or circuit sections. Capacitive isolation links are also used to minimize the transmission of interferences introduced by the environment from one circuit to another or from one section of a circuit to one another. It is also used in galvanic isolation, to isolate high voltages from one another or to isolate low voltage command circuits to high voltage power circuits. Capacitive isolation links also allow better integration compared to other systems based for example on electromagnetic isolators.

Capacitive isolation links usually make use of a dielectric in order to block direct current between isolated circuits sections of the electrical circuits or to block lowest-frequency currents between the circuits sections while allowing transfer of a higher frequency data signal. The isolation barrier usually includes one or more capacitors or transformers. For this reason, information data shape commonly used is square signals with very fast transients used for the edges of the signal followed by a maintained information level (no transient information) allowing to transmit only the edge variation of the signal through the capacitive barrier.

Nevertheless, common mode transients (CMT) may be caused ether as a result of different supply voltages and grounds that are present at different circuits or circuits sections or as the result of external interferences such as for example, radiation, electromagnetic fields, temperature variation. As a consequence, high frequency transients can corrupt the data transmission of a data signal across the isolation barrier. It is well known that addressing the effect of the CMT in a digital isolator is a challenge in designing such digital isolators.

Document SLLA284A "Digital Isolator Design Guide" from Texas Instrument, discloses capacitive isolation link devices including at least two data channels: a high-frequency channel (HF) with a bandwidth generally from 100kbps up to 150Mbps, and a low-frequency channel (LF) covering the range below down to dc. In principle, a single-ended input signal entering the HF-channel is split into a differential signal via the inverter gate at the input. The following capacitor-resistor networks differentiate the signal into small and narrow transients, which then are converted into rail-to-rail differential pulses by two comparators. The comparator outputs drive a NOR-gate flip-flop whose output feeds an output multiplexer. A decision logic (DCL) at the driving output of the flip-flop measures the durations between signal transients. If the duration between two consecutive transients exceeds a certain time limit (as in the case of a low-frequency signal) the DCL forces the output-multiplexer to switch from the high-frequency to the low-frequency channel. Because low-frequency input signals require the internal capacitors to assume prohibitively large values, these signals are pulse-width modulated (PWM) with the carrier frequency of an internal oscillator, thus creating a sufficiently high frequency, capable of passing the capacitive barrier. As the input is modulated, a low-pass filter (LPF) is needed to remove the high-frequency carrier from the actual data before passing it on to the output multiplexer.

Document US2017/0302225A1 discloses a system where the input circuit includes an on-off keying (OOK) modulator configured to generate a modulated data signal in response to the input data signal and the carrier signal. The output circuit includes a frequency shift keying (FSK) demodulator configured to detect a presence of the carrier signal in the modulated differential data signal and generate a demodulated data signal in response to the presence of the carrier signal.

Document EP0973305A1 discloses a capacitive insulating barrier system with a sawtooth signal as a carrier to generate a Pulse Width Modulation (PWM) signal as an input signal of the capacitive insulation barrier. There are two capacitors between input and output circuit which provide isolation between input and output circuits. A square pulse width modulated signal is used as transmitted signal from one side of the isolation barrier to the other.

US-6144326-B1 discloses digital isolation in a public telephony system. The analog input is sigma delta converted to a digital signal, modulated with a pulse density modulation and transmitted via capacitors in a differential mode through two lines. A clock is recovered from the differential signal, the signal decoded and converted to analog output.

Conventional capacitive links cannot transmit states but only transients such that when using a single capacitor, the system cannot make the difference between a parasitic and a transition of the data state to be transmitted. Therefore, two capacitors are used to transmit data on a differential way so that the unwanted parasitic can be removed. But using only 2 capacitors directly with the signal to be transmitted is risky. Indeed, in case of wrong communication for any reason such as described previously, the output signal can be stated in the wrong state and could theoretically remain in the wrong state for long time until some correction can be made or until a new state to be transmitted is defined. This could lead to a fatal failure in some applications. For this reason, many designs include a second pair of capacitors that is intended to transmit a modulated version of the data signal instead of the data signal itself. With a modulated square data signal, there is always a state change so that the capacitive link will transmit it. In case of "wrong pulse", it will be promptly corrected at the next edge of the modulated signal so that no fatal failure can happen.

However, with this second channel, as the input signal is modulated with a carrier frequency that is either asynchronous or synchronous with the input signal, the modulated signal further needs to be demodulated. This adds delay and jitter. This can be critical or not, depending on the final application.

In the capacitive links, a square or sinusoidal signal is applied at the input of a capacitive link. In case of sinusoidal waves, a specific demodulator is required, leading to some delay and jitter. It can also require some magnetics to generate such waveforms. In case of square waves, the capacitor will always transmit a rising edge followed by a constant state and then by a falling edge. The capacitive link is a high pass filter. These solutions require a demodulator in the receiver circuit to extract the envelope of the signal. This involves some time constant, leading to additional delay and output jitter as well as extra demodulation or detection circuits that increase the system size and limits its integration.

### Summary of the invention

It is an object of the present invention to provide a circuit for transmitting a digital signal through a capacitive isolation link with reduced, limited and known delay and reduced or no jitter with only one differential link and without the use of a PWM or OOK modulator and then without the need for FSK demodulation in order to reduce the size of the circuit and favoring integration in very small volumes. The invention is defined by the appended independent claims. Additional embodiments are defined by the dependent claims.

According to a first aspect, the invention provides a digital isolator for receiving a digital signal D, with reference to a first ground G1, and providing corresponding signals to output node R and output node S with reference to a second ground G2. The digital isolator may comprise at least one logic module for receiving said digital signal D. Said at least one logic module, may comprise a clock generator generating a clock signal CLK having a period T0 and, in a preferred embodiment, a pulse width shorter than T0/3. Said logic module is configured to provide first and second command signals to at least one sawtooth modulator. Said clock signal is used together with said input signal D to generate through said logic module, said logic commands to said sawtooth modulators. A first sawtooth modulator STM1 for receiving said first command signals is configured for providing a first sawtooth signal at a node A1, output of STM1. Said first sawtooth signal is composed of a fast rising edge triggered by a rising edge of the clock signal CLK, followed by a slow falling edge, when D equals 1 and is composed of a fast falling edge triggered by a rising edge of the clock signal CLK, followed by a slow rising edge, when D equals 0. A second sawtooth modulator STM2 is configured for receiving said second command signals, and for providing a second sawtooth signal at a node A2, output of STM2. Said second sawtooth signal is composed of a fast falling edge triggered by a rising edge of the clock signal CLK, followed by a slow rising edge, when D equals 1 and a fast rising edge triggered by a rising edge of the clock signal CLK, followed by a slow falling edge, when D equals 0 such that the two said sawtooth signals generated respectively by STM1 and STM2 provide data information of inversed logic. Said node A1 is the input node of a first isolation capacitor used for isolating the circuit sections of the system on a first channel of the differential circuit. B1 is the second node of the said first isolation capacitor. B1 is used as output of the first isolation capacitor for the said first channel of the differential link. The first isolation capacitor used as isolation barrier is also used as part of a high-pass filter together with dipole Z1. Z1 is connected between said node B1 and a bias voltage source with reference to a second ground G2. Said node A2 is the input node of a second isolation capacitor used for isolating the circuit sections of the system on the second channel of the said differential link. B2 is the second node of the said second isolation capacitor. B2 is used as output of the capacitive barrier for the second channel of the differential link. The second isolation capacitor used as isolation barrier is also used as part of a high-pass filter together with dipole Z2. Z2 is connected between said node B2 and said bias voltage source with reference to a second ground G2. A first threshold comparator having a first input connected to said node B1, and a second input connected to said node B2, produces a logical 1 output S when the difference between the value of its first input exceeds its second input by a threshold Th1, and logical 0 output otherwise. A second threshold comparator having a first input connected to said node B2, and a second input connected to said node B1, produce a logical 1 output R when its first input exceeds its second input by a threshold Th2, and a logical 0 output otherwise. The dipoles Z1, Z2 may be resistors. The bias voltage source may have a zero bias, i.e. be a short circuit. Preferably, the durations of the slow rising edges and/or of the slow falling edges at said nodes A1 and/or A2 are at least two times, four times, or more preferably ten times the durations of the corresponding fast falling edges and/or fast rising edges, respectively. The duration of the slow or fast riding edges may be determined as being the time needed for reaching a ratio such as 80% of a power supply voltage. The duration of the slow or fast falling edges may be determined as being the time needed for falling down to a ratio such as 20% of a power supply voltage.

In an embodiment, hereafter referred to as "anti-jitter embodiment", said logic module may comprise means for disabling the clock generator at a transition of the digital signal D, and for re-enabling the clock generator after a delay larger than or equal to 0.8*T0 afterwards. This provides an anti-jitter solution.

In a variation of said embodiment, hereafter referred to as "selector embodiment", an additional digital signal D1, with reference to said first ground G1, may be used as input digital signal, said logic module comprising additional means for disabling the clock generator when additional digital signal D1 is equal to logical 0. Said input signal D, with reference to said first ground G1, may then be used as a selector for sending a signal corresponding signal to additional digital signal D1 on output R or output S, with reference to said second ground G2, depending on the logic value of said signal D. Signal D acts as a selector for sending signal D1 either to output S or output R.

Preferably, said logic module may be configured for providing first command signals to said first sawtooth modulator STM1, said first command signals comprising logical signals SU1, SD1 and W1. Said logic module may also be configured for providing second command signals to said second sawtooth modulator STM2, said second command signals comprising logical signals SU2, SD2 and W2
- SU1 being equal to 1 when D is equal to 0 and equal to the inverse of the clock signal otherwise;
- SD1 being equal to the clock signal CLK, when D is equal to 0 and equal to 0 otherwise;
- W1 is equal to 0 or equal to CLK when D equals 0, and is equal to 1 or equal to not(CLK) when D equals 1.
- SU2 is equal to not(SD1);
- SD2 is equal to not(SU1)
- W2 is equal to not(W1).

The digital isolator may then comprise an SR latch, said signals at output nodes R and S being connected to corresponding inputs of said SR latch. The output of the SR latch is then a signal corresponding to digital signal D, having some delay and some jitter, and isolated from the input digital signal.

In said anti-jitter embodiment, said logic module may be configured for providing first command signals to said first sawtooth modulator STM1, said first command signals comprising logical signals SU1, SD1 and W1, and for providing second command signals to said second sawtooth modulator STM2, said second command signals comprising logical signals SU2, SD2 and W2. Said logical module comprising means for determining a digital signal Ddelayed, being digital signal D delayed by a duration equal to or longer than 0.8*T0,
- SU1 being equal to not(CLK) when D equals 1 and Ddelayed equals 1, and SU1 being equal to 1 otherwise;
- SD1 being equal to the clock signal CLK, when D is equal to 0 and Ddelayed is equal to 0, and SD1 being equal to 0 otherwise;
- W1 being equal to 0 or equal to CLK when D equals 0 and Ddelayed is equal to 0, W1 being equal to 1 or equal to not(CLK) when D equals 1 and Ddelayed equals 1, W1 being equal to 0 when D equals 0 and Ddelayed is equal to 1, W1 being equal to 1 when D equals 1 and Ddelayed equals 0;
- SU2 is equal to not(SD1);
- SD2 is equal to not(SU1)
- W2 is equal to not(W1).

In said selector embodiment of the invention, said logic module may be configured for providing first command signals to said first sawtooth modulator STM1, said first command signals comprising logical signals SU1, SD1 and W1, and for providing second command signals to said second sawtooth modulator STM2, said second command signals comprising logical signals SU2, SD2 and W2, said logical module comprising means for determining a digital signal Ddelayed, being digital signal D delayed by a duration equal to or longer than 0.8*T0;
- SU1 being equal to not(CLK) when D equals 1, Ddelayed equals 1 and D1 equals 1, and SU1 being equal to 1 otherwise;
- SD1 being equal to the clock signal CLK, when D is equal to 0, Ddelayed is equal to 0 and D1 equals 1, and SD1 being equal to 0 otherwise;
- W1 being equal to 0 or equal to CLK when D equals 0, Ddelayed equals 0, and D1 equals 1, W1 being equal to 1 or equal to not(CLK) when D equals 1, Ddelayed equals 1, and D1 equals 1, W1 being equal to 0 when D equals 0, Ddelayed equals 0, and D1 equals 0, W1 being equal to 1 when D equals 1, Ddelayed equals 1 and D1 equals 0;
- SU2 is equal to not(SD1);
- SD2 is equal to not(SU1);
- W2 is equal to not(W1).

Said first sawtooth modulator STM1 advantageously comprise
- a first low impedance controllable switch connected between a first power supply voltage V1 and said output node A1, being closed when command signal SU1 is equal to 0 and open otherwise;
- a second low impedance controllable switch connected between said node A1 and said first ground G1, being closed when command signal SD1 is equal to 1 and open otherwise;
- a first controllable switch in series with a current limiting dipole, connected between said first power supply voltage V1 and said node A1, said first controllable switch being open when command signal W1 is equal to 1 and closed otherwise;
- a second controllable switch in series with a current limiting dipole, connected between said node A1 and said first ground G1, second controllable switch being closed when command signal W1 is equal to 1 and open otherwise;
- a capacitor Cp1 between said node A1 and ground G1.

Said second sawtooth modulator STM2 may advantageously comprise
- a first low impedance controllable switch connected between a first power supply voltage V1 and said output node A2, being closed when command signal SU2 is equal to 0 and open otherwise;
- a second low impedance controllable switch connected between said node A2 and said first ground G1, being closed when command signal SD2 is equal to 1 and open otherwise;
- a first controllable switch in series with a current limiting dipole, connected between said first power supply voltage V1 and said node A2, said first controllable switch being open when command signal W2 is equal to 1 and closed otherwise;
- a second controllable switch in series with a current limiting dipole, connected between said node A2 and said first ground G1, second controllable switch being closed when command signal W2 is equal to 1 and open otherwise;
- a capacitor Cp2 between said node A2 and ground G1.

According to a second aspect, the invention provides a method for isolating a digital signal D, with reference to a first ground G1, and providing corresponding signals to output node R and output node S with reference to a second ground G2, comprising the steps of
- receiving said digital signal D, and providing first and second command signal, generating a clock signal CLK having a period T0, and, in a preferred embodiment, a pulse width shorter than T0/3;
- receiving said first command signals, and providing a first sawtooth signal at a node A1, said first sawtooth signal having a fast rising edge triggered by a rising edge of the clock signal CLK, followed by a slow falling edge, when D equals 1 and said first sawtooth signal having a fast falling edge triggered by a rising edge of the clock signal CLK, followed by a slow rising edge, when D equals 0;
- receiving said second command signals, and providing a second sawtooth signal at a node A2, said second sawtooth signal having a fast falling edge triggered by a rising edge of the clock signal CLK, followed by a slow rising edge, when D equals 1 and a fast rising edge triggered by a rising edge of the clock signal CLK, followed by a slow falling edge, when D equals 0;
- feeding said first sawtooth signal to a first isolation capacitor connected to said node A1, and obtaining a first isolated signal at a node B1 of said first isolation capacitor;
- high-pass filtering said first isolated signal, a high pass filter being formed by said first isolation capacitor and a first dipole Z1 connected between said node B1 and a bias voltage source with reference to a second ground G2;
- feeding said second sawtooth signal to a second isolation capacitor connected to said node A2, and obtaining a second isolated signal at a node B2 of said second isolation capacitor;
- high-pass filtering said second isolated signal, a high pass filter being formed by said second isolation capacitor and a second dipole Z2 connected between said node B2 and said bias voltage source with reference to a second ground G2;
- providing said first and second isolated signals to a first threshold comparator, producing an output S, being a logical 1 when said first isolated signal exceeds said second isolated signal by a threshold Th1, and logical 0 output otherwise;
- providing said first and second isolated signals to a second threshold comparator, producing an output R, being a logical 1 when said second isolated signal exceeds said first isolated signal by a threshold Th2, and logical 0 output otherwise.
Preferably, the durations of the slow rising edges and/or of the slow falling edges at said nodes A1 and/or A2 are at least two times, four times, or more preferably ten times the durations of the corresponding fast falling edges and/or fast rising edges, respectively.

The method may advantageously comprise the step of feeding said signals at output nodes R and S to corresponding inputs of an SR latch.

### Short description of the drawings

In the drawings:

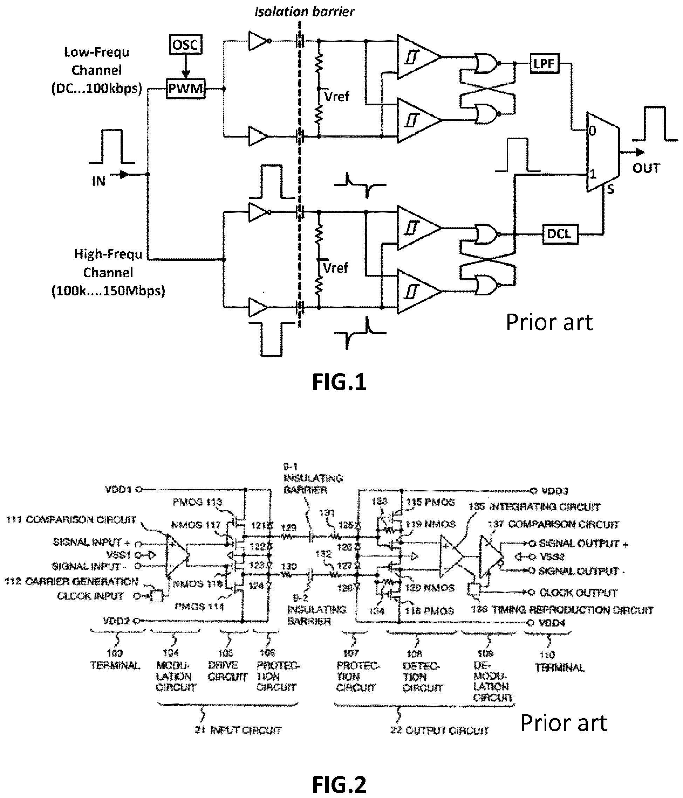

**Fig.1** is a conceptual block diagram of a known edge-based architecture of a digital isolator by Texas Instruments Incorporated from document SLLA284A.
**Fig.2** is the schematic of one CMOS technology implementation of known isolation coupler having a capacitive barrier. This figure is Fig.3 in document EP0973305A1.
   Further aspects of the invention will be explained in greater detail by way of examples and with reference to the accompanying drawings in which:
   **Fig.3a** is a block diagram of an isolator according to the invention,
   **Fig.3b** is a block diagram of an isolator according to the invention, comprising an SR latch;
   **Fig.4a** represents typical signals at nodes **A1** and **A2** of the isolator of Fig. 3a or 3b, in dependence of the clock signal **CLK,** when digital signal D equals 0;
   **Fig.4b** represents typical signals at specific nodes of the isolator of Fig. 3a or 3b.
   **Fig.5a, 5b****,****5c** are embodiments of a logic module for use in a digital insulator according to embodiments of the invention,
   **Fig.6a** and **6b** represent embodiments of sawtooth modulators for use in a digital insulator according to an embodiment of the invention.
   **Fig.7** show results of simulation of the anti-jitter embodiment of the invention.

The drawings of the figures are neither drawn to scale nor proportioned.

### Detailed description of embodiments of the invention

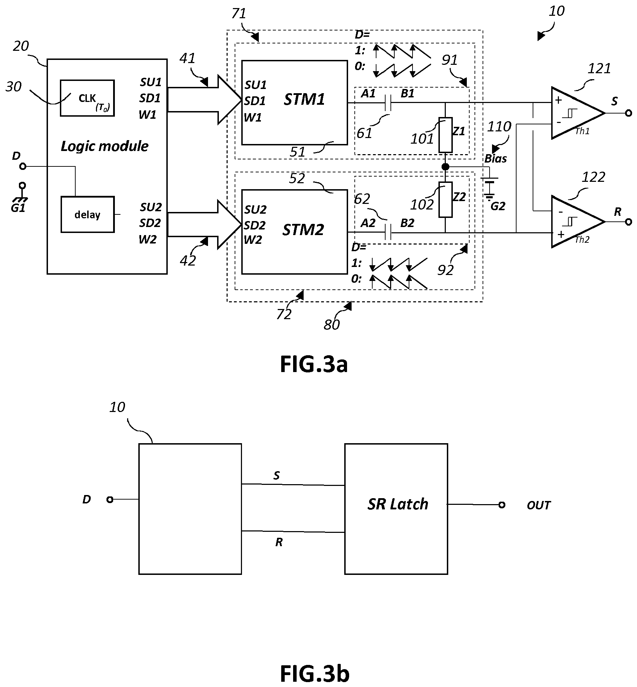

In **Fig.3a****,** depicts a block diagram of a digital isolator **10** according to the invention. The digital isolator **10** is for receiving a digital signal D, with reference to a first ground **G1,** and for providing corresponding output signals **S** and R with reference to a second ground **G2.** Signals **S and R** may for example be sent to an SR latch, as depicted on **Fig.3b****,** in order to regenerate said input signal **D** as signal **OUT.** Alternatively, signals **S and R** may be sent to low-pass filters or peak detectors in order to regenerate said input signal **D** as signal **OUT.**

A logic module **20** for receiving said digital signal D may comprise a clock generator **30** generating a clock signal CLK having a period **T0.** Said logic module is configured to provide command signals **(41, 42)** to at least one sawtooth modulator. Said logic module provides first command signals **41** and second command signals **42** to respectively sawtooth modulators STM1 **51** and STM2 **52,** in order to generate said sawtooth signals comprising a fast rising edge followed by a slow falling edge or a fast falling edge followed by a slow rising edge. A plateau may be present between a falling and a rising edge or between a rising and a falling edge. Said logic module can be also implemented in two parts, one for STM1 and one for STM2 at the condition that the same clock signal is used for both logic module blocks or that the signal clocks for the two blocks are synchronized.

The invention is based on producing and transmitting through the isolation capacitors **61** and **62** of respectively first channel **71** and second channel **72** of the differential link **80,** specific shaped waveform that are called in the present disclosure sawtooth signals, sent to respectively the input node **A1** of the isolation capacitors **61** and the input node **A2** of the isolation capacitors **62.**

Signals at node **A1** comprise a sequence of fast rising edges followed by slow falling edges, when D equals 1, and a sequence of fast falling edges followed by slow rising edges when D equals 0.

Signals at node **A2** comprise a sequence of slow falling edges followed by fast rising edges when D equals 0, and a sequence slow rising edges followed by fast falling edges when D equals 1.

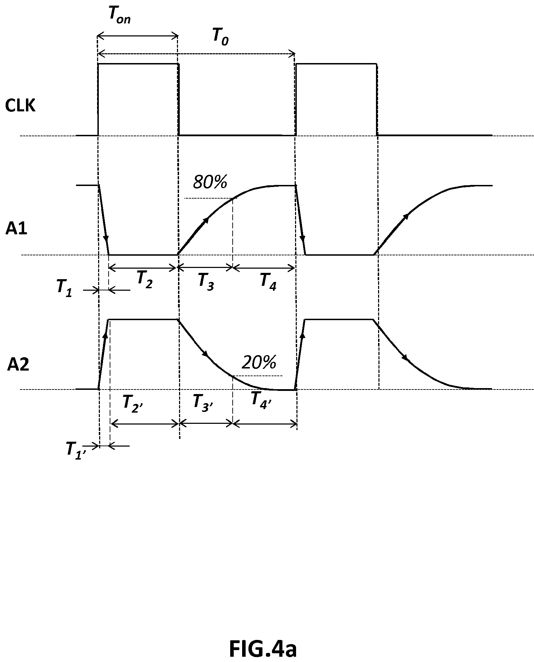

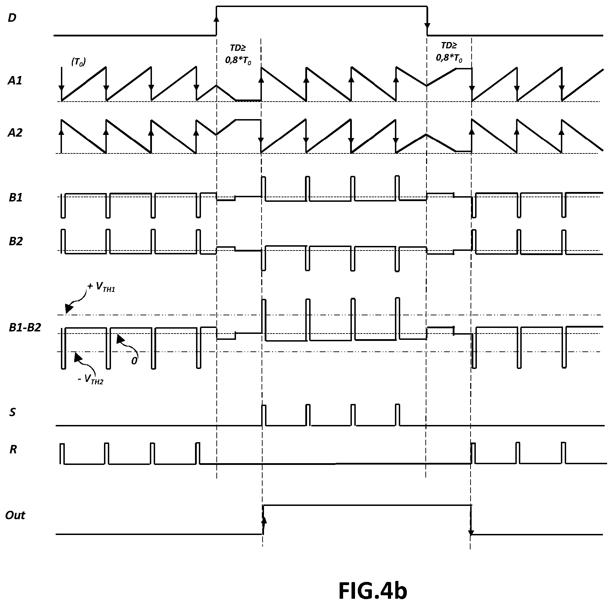

Signals at nodes **A1** and **A2** are also presented in **Fig.4a** and **Fig.4b****.** Edges of sawtooth signals may be either curves or linear segments.

Said node **A1** is the input node of the isolation capacitor **61** used for isolating the circuit sections of the system on a first channel **71** of the differential circuit **80.** Node **B1** is the second node of the said first isolation capacitor **61.** Node **B1** is used as output of the capacitive barrier. Said node **A2** is the input node of the isolation capacitor **62** used for isolating the circuit sections of the system on a second channel **72** of the differential circuit **80.** Node **B2** is the second node of the said second isolation capacitor **62.** Node **B2** is used as output of the capacitive barrier for the second channel **62** of the differential circuit.

As seen in **Fig.3a****,** the isolation capacitors **61** and **62** are also used as part of, respectively, high pass filters **91** and **92** together with impedances **101** and **102** both connected to the same bias voltage source **110** with reference to ground **G2.** High pass filters **91** and **92** allow to obtain respectively at each output nodes **B1** and **B2** of the isolation capacitors **61** and **62** successive peak pulses of same orientations while the data signal **D** remains constant as shown in **Fig.4b****.** To obtain such pulses after a capacitive isolation is impossible when using square or sinusoidal pulses. Indeed, when using square pulses, the high pass filter will always transmit a fast rising edge followed by a fast falling edge and so on, making it impossible to transmit successive data peaks of same orientation.

The sawtooth signal's logic value is defined by the orientation of the fast edge of the sawtooth signal. For example, a fast rising edge will define a logical 1 when a fast falling edge will define a logical 0. On a first channel **71** the sawtooth signal has the same logic value than said input signal **D,** such that said sawtooth signal at node **A1** has a fast falling edge followed by a slow rising edge when input signal **D** is 0 and a fast rising edge followed by a slow falling edge when input signal **D** is 1. On a second channel **72** the sawtooth signal has an opposite logic value than said input signal **D,** such that said sawtooth signal at node **A2** has a fast rising edge followed by a slow falling edge when input signal **D** is 0 and a fast falling edge followed by a slow rising edge when input signal **D** is 1.

When said first sawtooth signal is applied to node **A1,** said first sawtooth signal is filtered such that, at node **B1,** only fast transients of the said first sawtooth signal will form short pulses with large magnitude with orientation corresponding to the derivative of the input pulse. When a fast rising curve slope occurs at input node **A1,** a short positive pulse with large magnitude occurs at node **B1.** When a fast falling curve slope occurs at input node **A1,** a short negative pulse with large magnitude occurs at node **B1.** As the input signal is composed of sawtooth pulses, all fast edges are of same variation until the value of **D** is changed. As long as **D** is set to 1, sawtooth signal at node **A1** will be composed of fast rising edges followed by slow falling slopes such that at node **B1,** the filtering will produce successive short positive pulses with large magnitude followed by long and very small pulses of negative values as represented in **Fig.4b****.** When the value of **D** is changed to 0, the sawtooth signal at **A1** is composed of fast falling edges followed by slow rising slopes such that at node **B1,** the filtering will produce successive short negative pulses with large magnitude followed by long and very small pulses of positive values. The ratio of the duration of the fast falling/fast rising edges to the corresponding slow rising/slow falling edges is selected in order that the corresponding filtered pulse have sufficiently different amplitudes in order for the threshold comparators to transmit only when the differences between signals at nodes B1 and B2 are larger than a threshold. This ratio may be smaller than 1/2, 1/5 or even 1/10.

As the differential link 80 comprises two channels **71** and **72** of inversed logic, when a logic signal 1 is sent to the first line of the differential link, a logic signal 0 is sent to the second line of the differential link and when a logic signal 0 is sent to the first line of the differential link, a logic signal 1 is sent to the second line of the differential link. As a consequence, nodes **A1** and **A2,** respectively **B1** and **B2,** will receive signals of complementary logic values.

In case of unwanted parasitic signal injected on node B1 or node B2 producing a wrong information pulse due to surrounding electrical noise, the system will auto correct itself after a maximum time delay of one modulated signal period of time **T0** which is also the time between two fast edges of the sawtooth signals. This allows to drastically reduce the time during which the system may provide a wrong information.

Said sawtooth modulators **STM1 51** receives said first command signals **41.** It is configured for providing a first sawtooth signal at a node **A1,** output of **STM1.** Said first sawtooth signal at node **A1** is composed of a fast rising edge triggered by a rising edge of the clock signal **CLK,** followed by a slow falling edge when **D** equals 1 and is composed of a fast falling edge triggered by a rising edge of the clock signal **CLK,** followed by a slow rising edge, when **D** equals 0. The said second sawtooth modulator **STM2 52** is configured for receiving said second command signals **42,** and for providing a second sawtooth signal at a node **A2,** output of **STM2.** Said second sawtooth signal is composed of a fast falling edge triggered by a rising edge of the clock signal **CLK,** followed by a slow rising edge, when **D** equals 1 and a fast rising edge triggered by a rising edge of the clock signal **CLK,** followed by a slow falling edge, when **D** equals 0 such that the two said sawtooth signals provide data information of inversed logic.

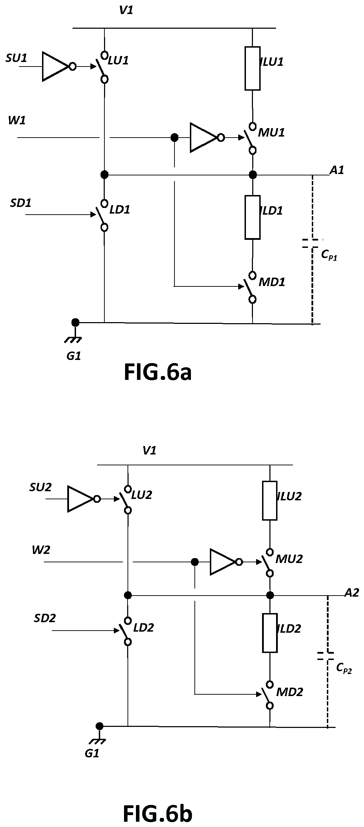

Sawtooth modulators **51** and **52** can be classically implemented for example but non exclusively, in CMOS technology, making use of transistors or micro-electromechanical switches as gates. A generic implementation using ideal switches or low-impedance switches is presented on figure **Fig.6a** and **6b****.**

In order to generate a sawtooth signal at node **A1,** said first sawtooth modulator **STM1 51,** represented on **Fig.3a** **and on** **Fig.6a****,** may comprise
- a first low impedance controllable switch **LU1** connected between a first power supply voltage **V1** and said output node **A1,** being closed when command signal **SU1** is equal to 0 and open otherwise;
- a second low impedance controllable switch **LD1** connected between said node **A1** and said first ground **G1,** being closed when command signal **SD1** is equal to 1 and open otherwise;
- a first controllable switch **MU1** in series with a current limiting dipole **ILU1** connected between said first power supply voltage **V1** and said node **A1,** said first controllable switch **MU1** being open when command signal **W1** is equal to 1 and closed otherwise;
- a second controllable switch **MD1** in series with a current limiting dipole **ILD1,** connected between said node **A1** and said first ground **G1,** second controllable switch being closed when command signal **W1** is equal to 1 and open otherwise;
- a capacitor **Cp1** between said node **A1** and ground **G1.**

The current limiting dipoles **ILU1** and **ILD1** may either be current sources or resistors or a combination thereof. The values of these components and of the capacitor **Cp1** are such that within the slow rising or falling edge, the sawtooth signals reaches at least 80% of **V1** or reaches less than 20% of **V1** respectively. In a specific embodiment, **Cp1** can be either a specific capacitor or a parasitic capacitance resulting from the technology used. A parasitic capacitance may result, e.g. from the circuit layout, the assembly such as bonding or connection.

To generate a fast rising edge of a sawtooth signal at node **A1, SU1** is set to close said switch **LU1** such that the capacitance **Cp1** is promptly charged to V1 through **LU1,** while **SD1** is set to open switch **LD1.**

To generate a slow rising edge of a sawtooth signal, **W1** is set to close said switch **MU1** such that the capacitance **Cp1** is charged to **V1** through **MU1** and **ILU1,** while **SD1** is set to open **LD1** and **SU1** is set to open **LU1.**

To generate a fast falling edge of a sawtooth signal, **SD1** is set to close said switch **LD1** such that the capacitance **Cp1** promptly discharge to ground **G1** through **LD1** while **SU1** is set to open switch **LU1.**

To generate a slow falling edge of a sawtooth signal, **W1** is set to close said switch **MD1** such that the capacitance **Cp1** is discharged to **G1** through **MD1 and ILD1,** while **SD1** is set to open **LD1** and **SU1** is set to open **LU1.**

In order to generate a sawtooth signal at node **A2,** said second sawtooth modulator **STM2 52,** represented on **Fig.3a** and **6b****,** may comprise
- a first low impedance controllable switch connected **LU2** between a first power supply voltage **V1** and said output node **A2,** being closed when command signal **SU2** is equal to 1 and open otherwise;
- a second low impedance **LD2** controllable switch connected between said node **A2** and said first ground **G1,** being closed when command signal **SD2** is equal to 0 and open otherwise;
- a first controllable switch **MU2** in series with a current limiting dipole **ILU2,** connected between said first power supply voltage **V1** and said node **A2,** said first controllable switch being open when command signal **W2** is equal to 1 and closed otherwise;
- a second controllable switch **MD2** in series with a current limiting dipole **ILD2,** connected between said node **A2** and said first ground **G1,** second controllable switch being closed when command signal **W2** is equal to 1 and open otherwise;
- a capacitor **Cp2** between said node **A2** and ground **G1.**

The current limiting dipoles **ILU2** and **ILD2** may either be current sources or resistors or a combination thereof. The values of these components and of the capacitor **Cp2** are such that within the slow rising or falling edge, the sawtooth signals reaches at least 80% of **V1** or is less than 20% of **V1** respectively. In a specific embodiment, **Cp2** can be either a specific capacitor or a parasitic capacitance from a technology. A parasitic capacitance may result, e.g. from the circuit layout, the assembly such as bonding or connection.

To generate a fast rising edge of a sawtooth signal at node **A2, SU2** is set to close said switch **LU2** such that the capacitance **Cp2** is promptly charged to **V1** through **LU2,** while **SD2** set to open switch **LD2.**

To generate a slow rising edge of a sawtooth signal, **W2** is set to close said switch **MU2** such that the capacitance **Cp2** is charged to **V1** through **MU2 and ILU2,** while **SD2** is set to open **LD2** and **SU2** is set to open **LU2.**

To generate a fast falling edge of a sawtooth signal, **SD2** is set to close said switch **LD2** such that the capacitance **Cp2** promptly discharge to ground **G1** through **LD2** while **SU2** is set to open switches **LU2.**

To generate a slow falling edge of a sawtooth signal, **W2** is set to close said switch **MD2** such that the capacitance **Cp2** is discharged to **G1** through **MD2 and ILD2,** while **SD2** is set to open **LD2** and **SU2** is set to open **LU2.**

A first threshold comparator **121** having a first input connected to said node **B1,** and a second input connected to said node **B2,** produces a logical 1 output **S** when the difference between the value of its first input exceeds its second input by a threshold **Th1,** and logical 0 output otherwise such that only positive **B1-B2** pulses larger than the threshold **Th1** will generate a logical 1 pulse at output **S.**

A second threshold comparator **122** having a first input connected to said node **B2,** and a second input connected to said node **B1,** produces a logical 1 output **R** when its first input exceeds its second input by a threshold **Th2,** and a logical 0 output otherwise such that only positive **B2-B1** pulses larger than the threshold **Th2** will generate la logical 1 pulse at the output **R.** These two threshold comparators allow to obtain non interleaved successive digital pulses at a frequency of the clock signal CLK, only on output **S** when input signal **D** is set to logic 1 and only on output **R** when input signal is set to 0. This allows the system to be set in the correct mode according to the channel **S** or **R** from where the fast output signal comes from. In case of large interferences at B1 or B2, if a wrong information is generated on output S or output R, the system corrects itself at the maximum time of a clock period after the end of the fast parasitic transient. A parasitic is considered large when it can induce a differential voltage large enough to toggle comparators **121** or **122.** In case of moderate parasitic at node B1 or node B2, the system will filter the wrong information aimed to the high-pass filters and will not take into account the wrong information making the system robust to moderate interferences on B1 or B2.

**Fig.4a** represents typical signals at nodes **A1** and **A2** of the isolator of Fig. 3a or 3b, in dependence of the clock signal **CLK,** when digital signal D equals 0. Referring to Fig.6a and Table I hereunder, when the clock signal rises (second line of table I, D=0, CLK=1), signal A1 undergoes a strong down movement, the capacitor C_{P1} being unloaded through closed switch LD1. The duration T1 of this down transition is very short because the resistance of the discharge circuit, including LD1 is low. Then, when the clock signal remains on (Tₒₙ), A1 remains low (Ground G1) in a plateau for a duration T2. When the clock signal goes to 0 (first line of table I hereunder, D=0, CLK=0), the signal at **A1** undergoes a slow rising edge for a duration T3. This duration is determined by the charge of capacitor Cp1, across current limiting dipole **ILU1.** When current limiting dipole **ILU1** is a resistor, the curve is the well known charge curve of an RC circuit. When the signal at A1 reaches at least 80% of V1, it may remain at this level or increase more for a duration T4 of a plateau until next rise of the clock signal. Similar transitions occur at node A2, with similar timings T1', T2', T3', T4' whose values may depend on the components of sawtooth modulator 52 of Fig.6b. The parameters of these circuits are selected in order that the durations of the fast falling edge T1, fast rising edge T1' are significantly shorter than the durations of the slow rising edge T3 and slow falling edge T3', respectively. This may be performed by adjusting the value of a resistor for ILU1 and ILU2 or of capacitors Cₚ₁ and Cₚ₂. Also the period of the clock T₀ and the pulse width Tₒₙ may be selected in order that enough time is given during period T3 for the signal A1 to rise to at least 80% of V1 before the next clock pulse occurs.

**Fig.4b** represents typical data pulses used to carry information at specific nodes of the circuit of **Fig.3****.** For clarity, the signals represented relate to a case where the rising/falling edges are very fast (T1 and T1' nearly zero), The clock pulse width Ton, very short (T2 nearly zero) and T4 nearly zero. Input signal **D** is a classical square digital signal carrying the information to be transmitted through the digital isolator. Specific sawtooth signal at node **A1** is used to transmit information through the isolation capacitor **61** and sawtooth signal at node **A2** is used to transmit information through the isolation capacitor **62.** Particular signals are found at node **B1** and **B2** corresponding respectively to signals at node **A1** and **A2** filtered by the high pass filters **91** and **92.** As shown on **Fig.4b****,** the signal at node **B1** is composed of successive pulses with a frequency corresponding to the clock frequency of the clock signal **CLK.** These pulses are positive with large magnitude when digital signal **D** is set to logic 1 and negative with large magnitude when digital signal **D** is set to logical 0. The signal at node **B2** is composed of successive pulses with a frequency corresponding to the clock frequency of the clock signal **CLK.** These pulses are negative with large magnitude when digital signal **D** is set to logic 1 and positive with large magnitude when digital signal **D** is set to logical 0. At the output of the threshold comparator **121,** only the difference between signals at nodes **B1** and **B2** that is greater than the threshold **Th1** is transmitted at node **S** and at the output of the threshold comparator **122,** only the difference between signals at nodes **B2** and **B1** that is greater than the threshold **Th2** is transmitted at node **R** such that pulses appear at node **S** only when said input signal **D** is set to logical 1 and pulses appear at node **R** only when said input signal **D** is set to logical 0 such that the two signals Sand R are not interleaved.

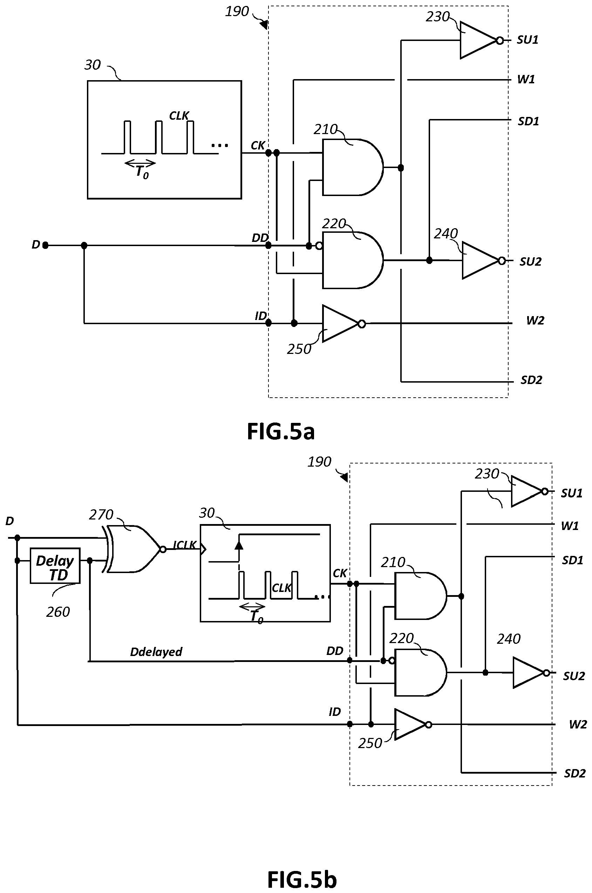

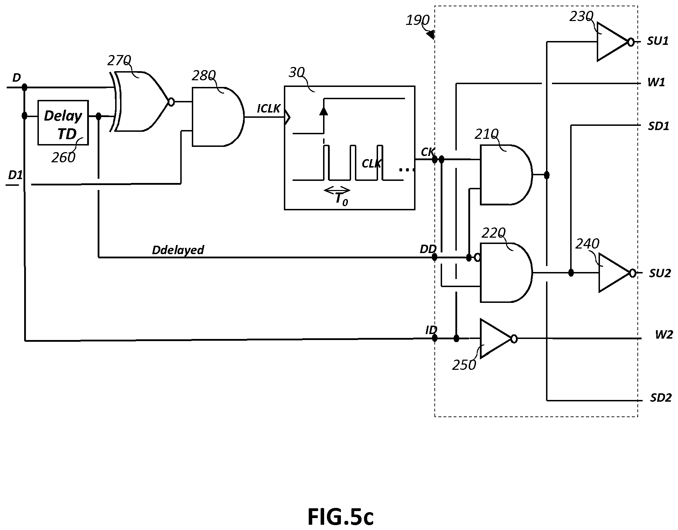

**Fig.5a, 5b****,****5c** are embodiments of said logic module **20** for use in a digital insulator according to embodiments of the invention.

Said logic module **20** is composed of a clock generator **30** with an output delivering a clock signal **CLK** at node **CK** and a command interface **CMD 190** for receiving digital signals at input nodes **DD, CK** and **ID.** Node **ID** is for receiving said input signal **D.**

Said command interface **CMD 190** is composed of:
- a first AND gate **210** with a first input connected to node **CK** and with a second input connected to node **DD** and an output connected to the input node **SD2** of STM2 **52.**
- a first inverter **230** with input connected to the output of said first AND gate **210** and output connected to the input node **SU1** of STM1 **51.**
- a second AND gate **220** with a first inverted input connected to node **DD** and with a second non-inverted input connected to node **CK,** and an output connected to the input node **SD1** of STM1 **51.**
- a second inverter **240** with input connected to the output of said second AND gate **220** and output connected to **SU2** of STM2 **52.**
- a third inverter **250** with input connected to node **ID** and output connected to input node **W2** of STM2 **52,**
- said node **ID** is connected to input **W1** of said STM1 **51.**

In the first embodiment presented in **Fig.5a****,** said nodes **DD** and **ID** are connected to the input of the digital isolator for receiving digital signal **D.** In this case, digital output signal **S** and **R** are not synchronized with the input signal **D.** After demodulation of the output signals **Sand R,** for example by using an RS gate, the demodulated signal will present a small delay and a jitter.

In the first embodiment presented in **Fig.5a****,** said logic module **20** is configured for providing first command signals to said first sawtooth modulator STM1 **51,** said first command signals comprising logical signals **SU1, SD1** and **W1,** and for providing second command signals to said second sawtooth modulator STM2 **52,** said second command signals comprising logical signals **SU2, SD2** and **W2**
- **SU1** being equal to 1 when **D** is equal to 0 and equal to the inverse of the clock signal otherwise;
- **SD1** being equal to the clock signal **CLK,** when **D** is equal to 0 and equal to 0 otherwise;
- **W1** is equal to 0 or equal to **CLK** when D equals 0 and is equal to 1 or equal to not(**CLK**) when **D** equals 1.
- **SU2** is equal to not(**SD1**);
- **SD2** is equal to not(**SU1**)
- **W2** is equal to not(**W1**).
This command logic is summarized in the following table:

**Table I**

| **D** | **CLK** | **SU1 (S̅D̅2̅ )** | **SD1 (S̅U̅2̅ )** | **W1 (W̅2̅ )** |
|---|---|---|---|---|
| 0 | 0 | 1 | 0 | 0 |
| 0 | 1 | 1 | 1 | X |
| 1 | 0 | 1 | 0 | 1 |
| 1 | 1 | 0 | 0 | X |

In said "anti-jitter" embodiment presented in **Fig.5b****,** an anti-jitter solution is proposed characterized in that said logic module **20** comprises means for disabling the clock generator **30** at a transition of the digital signal **D,** and for re-enabling synchronously the clock generator after a delay **TD** afterwards. Such disabling is performed for downward and upward transitions of digital signal D. The delay TD is preferably larger than 0.5*T0, e.g. 0.6 or 0.7*T0, and more preferably larger than 0.8*T0.

In this anti-jitter embodiment, said logic module **20** is composed of:
- a clock generator **30** with an output delivering a clock signal **CLK** at node **CK.** Said clock generator **30** has a clock enabling input **ICLK** enabling clock pulses **CLK** when the digital input at input **ICLK** is set to logical 1 and disabling clock pulses **CLK** when the digital input at input **ICLK** is set to logical 0.
- a command interface **CMD 190** for receiving digital signals at input nodes **DD, CK** and **ID** and providing logical signals **SU1, SD1, W1, SU2, SD2** and **W2,**
- a delay line 260 having an input connected to the input of the digital isolator for receiving signal **D** and an output connected to node DD and providing an output signal **Ddelayed** composed of the input signal at node **D** delayed by a time delay TD,
- an XNOR gate **270** having the output connected to input **ICLK** of said clock generator 30 and first input connected to node **DD** and a second input connected to the output of said delay line **260,**
- said node **ID** is connected to the input of the digital isolator for receiving digital signal **D.**

In this anti-jitter embodiment, said logic module **20** is configured for providing first command signals to said first sawtooth modulator STM1 **51,** said first command signals comprising logical signals **SU1, SD1** and **W1,** and for providing second command signals to said second sawtooth modulator STM2 **52,** said second command signals comprising logical signals **SU2, SD2** and **W2,** said logical module comprising means for determining a digital signal Ddelayed, being digital signal **D** delayed by a duration equal to or longer than 0.8*T0
- **SU1** being equal to not(**CLK**) when **D** equals 1 and **Ddelayed** equals 1, and **SU1** being equal to 1 otherwise;
- **SD1** being equal to the clock signal **CLK,** when **D** is equal to 0 and **Ddelayed** is equal to 0, and SD1 being equal to 0 otherwise;
- **W1** being equal to 0 or equal to **CLK** when **D** equals 0 and **Ddelayed** is equal to 0, **W1** being equal to 1 or equal to not(**CLK**) when **D** equals 1 and **Ddelayed** equals 1, **W1** being equal to 0 when **D** equals 0 and **Ddelayed** is equal to 1, **W1** being equal to 1 when **D** equals 1 and **Ddelayed** equals 0;
- **SU2** is equal to not(**SD1**);
- **SD2** is equal to not(**SU1**)
- **W2** is equal to not(**W1**).

In embodiment of **FIG.5b****,** input data **D** is internally delayed by a delay **TD** equal to or larger than **T0***0.8 to define a preset time lapse whenever the state of **D** is toggling. During this preset time lapse, signals at node **A1** and node **A2** are preset to the correct initial state without applying any fast transition during this preset time lapse. At time **TD** after an input data change, the correct sawtooth signal fast transient can be applied on nodes **A1** and **A2.** This introduces a constant delay of about **TD** in the transmission, but the jitter is reduced to close to zero on demodulated **S** and **R** signals with reference to the input data D.
This command logic is summarized in the following table:

**Table II**

| **D** | **Ddelayed** | **CLK** | **SU1 (S̅D̅2̅ )** | **SD1 (S̅U̅2̅ )** | **W1 (W̅2̅ )** |
|---|---|---|---|---|---|
| 0 | 0 | 0 | 1 | 0 | 0 |
| 0 | 0 | 1 | 1 | 1 | X |
| 1 | 1 | 0 | 1 | 0 | 1 |
| 1 | 1 | 1 | 0 | 0 | X |
| 0 | 1 | 0 | 1 | 0 | 0 |
| 0 | 1 | 1 | 1 | 0 | 0 |
| 1 | 0 | 0 | 1 | 0 | 1 |
| 1 | 0 | 1 | 1 | 0 | 1 |

In the "selector" embodiment presented in **Fig.5c****,** said logic module **20** is adapted for receiving a second digital signal **D1** characterized in that said logic module **20** may comprise additional means for disabling the clock generator **30** when additional digital signal **D1** is equal to logical 0.

In this "selector" embodiment, an additional digital signal **D1,** with reference to a first ground **G1,** is used as input digital signal, and said input signal **D,** with reference to said first ground **G1,** is used as a selector for sending a corresponding signal of said additional digital signal **D1** on output **R** or output **S,** with reference to a second ground **G2,** depending on the logic value of said signal **D.**

In this "selector" embodiment presented in **Fig.5c****,** said logic module **20** is composed of:
- a clock generator 30 with an output delivering a clock signal **CLK** at node **CK.** Said clock generator 30 has a clock enabling input **ICLK** enabling clock pulses **CLK** when the digital input at input **ICLK** is set to logical 1 and disabling clock pulses **CLK** when the digital input at input **ICLK** is set to logical 0.
- a command interface CMD 190 for receiving digital signals at input nodes **DD, CK** and **ID** and providing logical signals **SU1, SD1, W1, SU2, SD2 and W2,**
- a delay line 260 having an input connected to the input of the digital isolator for receiving signal **D** and an output connected to node **DD** and providing an output signal **Ddelayed** composed of the input signal at node **D** delayed by a time delay **TD,**
- an XNOR gate 270 having a first input connected to the input of the digital isolator for receiving digital signal **D,** and a second input connected to the output of said delay line 260,
- said node **DD** is connected to the output of said delay line 260,
- a third AND gate 280 having a first input connected to the output of the XNOR gate 270 and a second input connected to the second input of the digital isolator for receiving additional digital signal **D1,** and an output connected to input **ICLK** of said clock generator 30.

In this third embodiment presented in **Fig.5c****,** said logic module is configured for providing first command signals to said first sawtooth modulator **STM1,** said first command signals comprising logical signals **SU1, SD1** and **W1,** and for providing second command signals to said second sawtooth modulator **STM2,** said second command signals comprising logical signals **SU2, SD2** and **W2,** said logical module comprising means for determining a digital signal **Ddelayed,** being digital signal **D** delayed by a duration equal to or longer than **TD** = 0.8***T0**;
- **SU1** being equal to not(**CLK**) when **D** equals 1, **Ddelayed** equals 1 and **D1** equals 1, and **SU1** being equal to 1 otherwise;
- **SD1** being equal to the clock signal **CLK,** when **D** is equal to 0, **Ddelayed** is equal to 0 and **D1** equals 1, and **SD1** being equal to 0 otherwise;
- **W1** being equal to 0 or equal to **CLK** when **D** equals 0, **Ddelayed** equals 0, and **D1** equals 1, **W1** being equal to 1 or equal to not(**CLK**) when **D** equals 1, **Ddelayed** equals 1, and **D1** equals 1, **W1** being equal to 0 when D equals 0, **Ddelayed** equals 0, and **D1** equals 0, **W1** being equal to 1 when **D** equals 1, **Ddelayed** equals 1 and **D1** equals 0;
- **SU2** is equal to not(**SD1**);
- **SD2** is equal to not(**SU1**);
- **W2** is equal to not(**W1**).
This command logic is summarized in the following table:

**Table III**

| **D1** | **D=Ddelayed** | **CLK** | **SU1 (S̅D̅2̅ )** | **SD1 (S̅U̅2̅ )** | **W1 (W̅2̅ )** |
|---|---|---|---|---|---|
| 1 | 0 | 0 | 1 | 0 | 0 |
| 1 | 0 | 1 | 1 | 1 | X |
| 1 | 1 | 0 | 1 | 0 | 1 |
| 1 | 1 | 1 | 0 | 0 | X |
| 0 | 0 | 0 | 1 | 0 | 0 |
| 0 | 0 | 1 | 1 | 0 | 0 |
| 0 | 1 | 0 | 1 | 0 | 1 |
| 0 | 1 | 1 | 1 | 0 | 1 |

In this third embodiment presented in **Fig.5c****,** the same function than in the case of the second embodiment of **Fig.5b** is obtained when **D1** is set to a constant logical 1. The same function than in the case of the first embodiment of **Fig.5a** is obtained when **D1** is set to a constant logical 1 and when the delay time **TD** is set to 0.

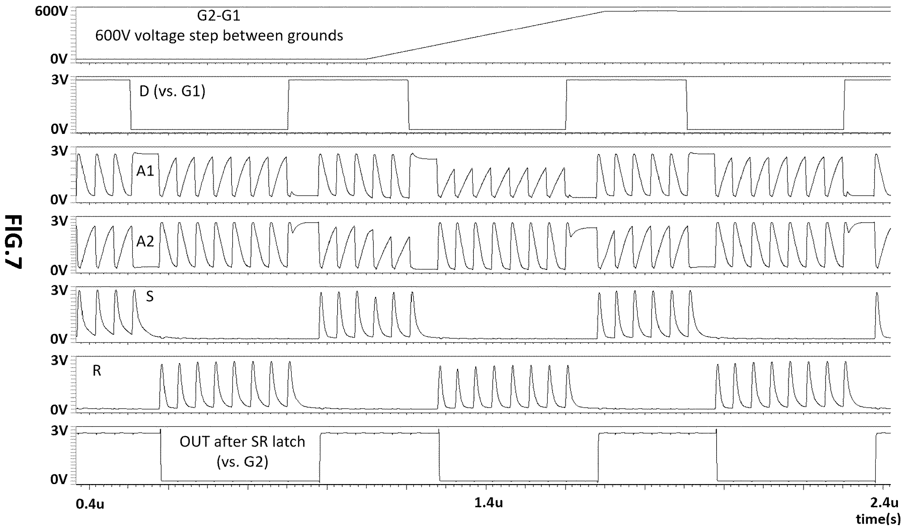

**Fig.7** show results of simulation of the anti-jitter embodiment of the invention. A 600 V linear increase of the voltage of **G2** with respect to **G1** between times 1.1 µs and 1.7 µs. Input signal **D,** between 0 V and 3 V with respect to ground **G1,** is transmitted without error to signal OUT, with constant delay TD, between 0 V and 3 V with respect to ground **G2.**

As is well known to the skilled person, the low impedance controllable switches, and medium impedance controllable switches used in the invention may be implemented in various ways, such, for example with MOSFETS, bipolar or any other kind of transistors or any kind of device that can modulate a conduction channel or any mechanical switching .

## Claims

1. A digital isolator (10) for receiving a digital signal D, with reference to a first ground G1, and providing corresponding signals to output node R and output node S with reference to a second ground G2, comprising
- a logic module (20) for receiving said digital signal D, and for providing first (41) and second (42) command signal, said logic module (20) comprising a clock generator (30) generating a clock signal CLK having a period T0;
- a first sawtooth modulator (51) STM1 for receiving said first command signals (41), and configured for providing a first sawtooth signal at a node A1, said first sawtooth signal having a fast rising edge triggered by a rising edge of the clock signal CLK, followed by a slow falling edge, when D equals 1 and said first sawtooth signal having a fast falling edge triggered by a rising edge of the clock signal CLK, followed by a slow rising edge, when D equals 0;
- a second sawtooth modulator (52) STM2 for receiving said second command signals (42), and configured for providing a second sawtooth signal at a node A2, said second sawtooth signal having a fast falling edge triggered by a rising edge of the clock signal CLK, followed by a slow rising edge, when D equals 1 and a fast rising edge triggered by a rising edge of the clock signal CLK, followed by a slow falling edge, when D equals 0;
- a first isolation capacitor (61) connected to said node A1, and to a node B1;
- a first dipole (101) Z1 connected between said node B1 and a bias voltage source (110) with reference to a second ground G2;
- a second isolation capacitor (62) connected to said node A2, and to a node B2;
- a second dipole (102) Z2 connected between said node B2 and said bias voltage source (110);
- a first threshold comparator (121) having a first input connected to said node B1, and a second input connected to said node B2, producing a logical 1 output S when its first input exceeds its second input by a threshold Th1, and logical 0 output otherwise;
- a second threshold comparator (122) having a first input connected to said node B2, and a second input connected to said node B1, producing a logical 1 output R when its first input exceeds its second input by a threshold Th2, and a logical 0 output otherwise.

2. A digital isolator (10) according to claim 1, **characterized in that** the durations of the slow rising edges and/or of the slow falling edges at said nodes A1 and/or A2 are at least two times the durations of the corresponding fast falling edges and/or fast rising edges, respectively.

3. A digital isolator (10) according to claim 1 or 2, **characterized in that** said clock signal CLK has a pulse width shorter than T0/3.

4. A digital isolator (10) according to any of claims 1 to 3, **characterized in that** said logic module (20) comprises means for disabling the clock generator (30) at a transition of the digital signal D, and for reenabling the clock generator after a delay larger TD.

5. A digital isolator (10) according to claim 4, **characterized in that** said delay TD is larger than 0.5*T0, 0.6*T0, 0.7*T0 ,0.8*T0 or T0.

6. A digital isolator (10) according to claim 4 or 5, **characterized in that** it is adapted for receiving an additional digital signal D1 with reference to said first ground G1 **characterized in that** said logic module (20) comprises additional means for disabling the clock generator (30) when additional digital signal D1 is equal to logical 0.

7. A digital isolator (10) according to any of claims 1 to 3 **characterized in that** said logic module (20) is configured for providing first command signals (41) to said first sawtooth modulator (51) STM1, said first command signals (41) comprising logical signals SU1, SD1 and W1, and for providing second command signals (42) to said second sawtooth modulator (52) STM2, said second command signals comprising logical signals SU2, SD2 and W2
- SU1 being equal to 1 when D is equal to 0 and equal to the inverse of the clock signal otherwise;
- SD1 being equal to the clock signal CLK, when D is equal to 0 and equal to 0 otherwise;
- W1 is equal to 0 or equal to CLK when D equals 0, and is equal to 1 or equal to not(CLK) when D equals 1.
- SU2 is equal to not(SD1);
- SD2 is equal to not(SU1);
- W2 is equal to not(W1).

8. A digital isolator (10) according to claim 7 **characterized in that** it comprises an SR latch, said signals at output nodes R and S being connected to corresponding inputs of said SR latch.

9. A digital isolator (10) according to claims 4 or 5 **characterized in that** said logic module (20) is configured for providing first command signals (41) to said first sawtooth modulator (51) STM1, said first command signals (41) comprising logical signals SU1, SD1 and W1, and for providing second command signals (42) to said second sawtooth modulator (52) STM2, said second command signals 42) comprising logical signals SU2, SD2 and W2, said logical module (20) comprising means for determining a digital signal Ddelayed, being digital signal D delayed by a duration equal to or longer than 0.8*T0
- SU1 being equal to not(CLK) when D equals 1 and Ddelayed equals 1, and SU1 being equal to 1 otherwise;
- SD1 being equal to the clock signal CLK when D is equal to 0 and Ddelayed is equal to 0, and SD1 being equal to 0 otherwise;
- W1 being equal to 0 or equal to CLK when D equals 0 and Ddelayed is equal to 0, W1 being equal to 1 or equal to not(CLK) when D equals 1 and Ddelayed equals 1, W1 being equal to 0 when D equals 0 and Ddelayed is equal to 1, W1 being equal to 1 when D equals 1 and Ddelayed equals 0;
- SU2 is equal to not(SD1);
- SD2 is equal to not(SU1);
- W2 is equal to not(W1).

10. A digital isolator (10) according to claim 6 **characterized in that** said logic module (20) is configured for providing first command signals (41) to said first sawtooth modulator (51) STM1, said first command signals (41) comprising logical signals SU1, SD1 and W1, and for providing second command signals (42) to said second sawtooth modulator (52) STM2, said second command signals (42) comprising logical signals SU2, SD2 and W2, said logical module comprising means for determining a digital signal Ddelayed, being digital signal D delayed by a duration equal to or longer than 0.8*T0;
- SU1 being equal to not(CLK) when D equals 1, Ddelayed equals 1 and D1 equals 1, and SU1 being equal to 1 otherwise;
- SD1 being equal to the clock signal CLK, when D is equal to 0, Ddelayed is equal to 0 and D1 equals 1, and SD1 being equal to 0 otherwise;
- W1 being equal to 0 or equal to CLK when D equals 0, Ddelayed equals 0, and D1 equals 1, W1 being equal to 1 or equal to not(CLK) when D equals 1 Ddelayed equals 1, and D1 equals 1, W1 being equal to 0 when D equals 0, Ddelayed equals 0, and D1 equals 0, W1 being equal to 1 when D equals 1, Ddelayed equals 1 and D1 equals 0;
- SU2 is equal to not(SD1);
- SD2 is equal to not(SU1);
- W2 is equal to not(W1).

11. Digital isolator according to any of preceding claims **characterized in that** said first sawtooth modulator **STM1 51** comprises
- a first low impedance controllable switch **LU1** connected between a first power supply voltage **V1** and said output node A1, being closed when command signal SU1 is equal to 0 and open otherwise;
- a second low impedance controllable switch **LD1** connected between said node **A1** and said first ground **G1,** being closed when command signal **SD1** is equal to 1 and open otherwise;
- a first controllable switch **MU1** connected in series with a current limiting dipole **ILU1** between said first power supply voltage **V1** and said node **A1,** said first controllable switch **MU1** being open when command signal **W1** is equal to 1 and closed otherwise;
- a second controllable switch **MD1** connected in series with a current limiting dipole **ILD1** between said node **A1** and said first ground **G1,** said second controllable switch being closed when command signal **W1** is equal to 1 and open otherwise;
- a capacitor **Cp1** between said node **A1** and ground **G1.**

12. Digital isolator according to any of preceding claims **characterized in that** said second sawtooth modulator **STM2 52** comprises
- a first low impedance controllable switch **LU2** connected between a first power supply voltage **V1** and said output node **A2,** being closed when command signal **SU2** is equal to 0 and open otherwise;
- a second low impedance controllable switch **LD2** connected between said node **A2** and said first ground **G1,** being closed when command signal **SD2** is equal to 1 and open otherwise;
- a first controllable switch **MU2** connected in series with a current limiting dipole **ILU2** between said first power supply voltage **V1** and said node **A2,** said first controllable switch being open when command signal **W2** is equal to 1 and closed otherwise;
- a second controllable switch **MD2** connected in series with a current limiting dipole **ILD2,** between said node **A2** and said first ground **G1,** said second controllable switch being closed when command signal **W2** is equal to 1 and open otherwise;
- a capacitor **Cp2** between said node **A2** and ground **G1.**

13. A method for isolating a digital signal D, with reference to a first ground G1, and providing corresponding signals to output node R and output node S with reference to a second ground G2, comprising the steps of
- receiving said digital signal D, and providing first (41) and second (42) command signal, generating a clock signal CLK having a period T0;
- receiving said first command signals (41), and providing a first sawtooth signal at a node A1, said first sawtooth signal having a fast rising edge triggered by a rising edge of the clock signal CLK, followed by a slow falling edge, when D equals 1 and said first sawtooth signal having a fast falling edge triggered by a rising edge of the clock signal CLK, followed by a slow rising edge, when D equals 0;
- receiving said second command signals (42), and providing a second sawtooth signal at a node A2, said second sawtooth signal having a fast falling edge triggered by a rising edge of the clock signal CLK, followed by a slow rising edge, when D equals 1 and a fast rising edge triggered by a rising edge of the clock signal CLK, followed by a slow falling edge, when D equals 0;
- feeding said first sawtooth signal to a first isolation capacitor (61) connected to said node A1, and obtaining a first isolated signal at a node B1 of said first isolation capacitor (61);
- high-pass filtering said first isolated signal, a high pass filter being formed by said first isolation capacitor and a first dipole (101) Z1 connected between said node B1 and a bias voltage source (110) with reference to a second ground G2;
- feeding said second sawtooth signal to a second isolation capacitor (62) connected to said node A2, and obtaining a second isolated signal at a node B2 of said second isolation capacitor (62);
- high-pass filtering said second isolated signal, a high pass filter being formed by said second isolation capacitor (62) and a second dipole (102) Z2 connected between said node B2 and said bias voltage source (110) with reference to a second ground G2;
- providing said first and second isolated signals to a first threshold comparator (121), producing an output S, being a logical 1 when said first isolated signal exceeds said second isolated signal by a threshold Th1, and logical 0 output otherwise;
- providing said first and second isolated signals to a second threshold comparator (122), producing an output R, being a logical 1 when said second isolated signal exceeds said first isolated signal by a threshold Th2, and logical 0 output otherwise.

14. A method according to claim 13, **characterized in that** the durations of the slow rising edges and/or of the slow falling edges at said nodes A1 and/or A2 are at least two times the durations of the corresponding fast falling edges and/or fast rising edges, respectively.

15. A method according to claim 13 or 14 **characterized in that** said clock signal CLK has pulse width shorter than T0/3

16. A method according to any of claims 13 to 15 **characterized in that** it comprises the step of feeding said signals at output nodes R and S to corresponding inputs of an SR latch.

## Patentansprüche

1. Digitaler Isolator (10) zum Empfangen eines digitalen Signals D unter Bezugnahme auf eine erste Masse G1 und Liefern entsprechender Signale an einen Ausgangsknoten R und Ausgangsknoten S unter Bezugnahme auf eine zweite Masse G2, umfassend
- ein Logikmodul (20) zum Empfangen des digitalen Signals D und zum Liefern eines ersten (41) und zweiten (42) Befehlssignals, wobei das Logikmodul (20) einen Taktgenerator (30) umfasst, der ein Taktsignal CLK mit einer Periode T0 generiert;
- einen ersten Sägezahnmodulator (51) STM1 zum Empfangen der ersten Befehlssignale (41) und konfiguriert zum Liefern eines ersten Sägezahnsignals an einen Knoten A1, wobei das erste Sägezahnsignal eine durch eine steigende Flanke des Taktsignals CLK ausgelöste schnell ansteigende Flanke aufweist, gefolgt von einer langsam fallenden Flanke, wenn D gleich 1 ist und das erste Sägezahnsignal eine durch eine steigende Flanke des Taktsignals CLK ausgelöste schnell fallende Flanke aufweist, gefolgt von einer langsam ansteigenden Flanke, wenn D gleich 0 ist;
- einen zweiten Sägezahnmodulator (52) STM2 zum Empfangen der zweiten Befehlssignale (42) und konfiguriert zum Liefern eines zweiten Sägezahnsignals an einen Knoten A2, wobei das zweite Sägezahnsignal eine durch eine steigende Flanke des Taktsignals CLK ausgelöste schnell fallende Flanke aufweist, gefolgt von einer langsam ansteigenden Flanke, wenn D gleich 1 ist, und eine durch eine steigende Flanke des Taktsignals CLK ausgelöste schnell ansteigende Flanke, gefolgt von einer langsam fallenden Flanke, wenn D gleich 0 ist;
- einen ersten Trennkondensator (61), der an den Knoten A1 und an einen Knoten B1 angeschlossen ist;
- einen ersten Dipol (101) Z1, der zwischen den Knoten B1 und eine Vorspannungsquelle (110) unter Bezugnahme auf eine zweite Masse G2 geschaltet ist;
- einen zweiten Trennkondensator (62), der an den Knoten A2 und an einen Knoten B2 angeschlossen ist;
- einen zweiten Dipol (102) Z2, der zwischen den Knoten B2 und die Vorspannungsquelle (110) geschaltet ist;
- einen ersten Schwellwertvergleicher (121) mit einem an den Knoten B1 angeschlossenen ersten Eingang und einem an den Knoten B2 angeschlossenen zweiten Eingang,
Erzeugen eines Ausgangs S mit einer logischen 1, wenn sein erster Eingang seinen zweiten Eingang um einen Schwellwert Th1 übersteigt, und ansonsten einen Ausgang mit einer logischen 0;
- einen zweiten Schwellwertvergleicher (122) mit einem an den Knoten B2 angeschlossenen ersten Eingang und einem an den Knoten B1 angeschlossenen zweiten Eingang,
Erzeugen eines Ausgangs R mit einer logischen 1, wenn sein erster Eingang seinen zweiten Eingang um einen Schwellwert Th2 übersteigt, und ansonsten einem Ausgang mit einer logischen 0.

2. Digitaler Isolator (10) nach Anspruch 1, **dadurch gekennzeichnet, dass** die Dauern der langsam steigenden Flanken und/oder der langsam fallenden Flanken an den Knoten A1 und/oder A2 jeweils mindestens das Doppelte der Dauern der entsprechenden schnell fallenden Flanken und/oder schnell ansteigenden Flanken sind.

3. Digitaler Isolator (10) nach Anspruch 1 oder 2, **dadurch gekennzeichnet, dass** das Taktsignal CLK eine Impulsbreite aufweist, die kürzer ist als T0/3.

4. Digitaler Isolator (10) nach einem der Ansprüche 1 bis 3, **dadurch gekennzeichnet, dass** das Logikmodul (20) Mittel zum Deaktivieren des Taktgenerators (30) bei einem Übergang des digitalen Signals D und zum Reaktivieren des Taktgenerators nach einer Verzögerung größer TD umfasst.

5. Digitaler Isolator (10) nach Anspruch 4, **dadurch gekennzeichnet, dass** die Verzögerung TD größer ist als 0,5*T0, 0,6*T0, 0,7*T0, 0,8*T0 oder T0.

6. Digitaler Isolator (10) nach Anspruch 4 oder 5, **dadurch gekennzeichnet, dass** er ausgelegt ist zum Empfangen eines zusätzlichen digitalen Signals D1 unter Bezugnahme auf die erste Masse G1, **dadurch gekennzeichnet, dass** das Logikmodul (20) zusätzliche Mittel zum Deaktivieren des Taktgenerators (30), wenn das zusätzliche digitale Signal D1 gleich einer logischen 0 ist, umfasst.

7. Digitaler Isolator (10) nach einem der Ansprüche 1 bis 3, **dadurch gekennzeichnet, dass** das Logikmodul (20) konfiguriert ist zum Liefern erster Befehlssignale (41) an den ersten Sägezahnmodulator (51) STM1, wobei die ersten Befehlssignale (41) logische Signale SU1, SD1 und W1 umfassen, und zum Liefern zweiter Befehlssignale (42) an den zweiten Sägezahnmodulator (52) STM2, wobei die zweiten Befehlssignale Logiksignale SU2, SD2 und W2 umfassen, wobei
- SU1 gleich 1 ist, wenn D gleich 0 ist, und ansonsten gleich dem Kehrwert des Taktsignals;
- SD1 gleich dem Taktsignal CLK ist, wenn D gleich 0 ist, und ansonsten gleich 0;
- W1 gleich 0 oder gleich CLK ist, wenn D gleich 0, und gleich 1 oder gleich not(CLK) ist, wenn D gleich 1,
- SU2 gleich not(SD1) ist;
- SD2 gleich not(SU1) ist;
- W2 gleich not(W1) ist.

8. Digitaler Isolator (10) nach Anspruch 7, **dadurch gekennzeichnet, dass** er einen SR-Zwischenspeicher umfasst, wobei die Signale an Ausgangsknoten R und S an entsprechende Eingänge des SR-Zwischenspeichers angeschlossen sind.

9. Digitaler Isolator (10) nach Ansprüchen 4 oder 5, **dadurch gekennzeichnet, dass** das Logikmodul (20) konfiguriert ist zum Liefern erster Befehlssignale (41) an den ersten Sägezahnmodulator (51) STM1, wobei die ersten Befehlssignale (41) logische Signale SU1, SD1 und W1 umfassen, und zum Liefern zweiter Befehlssignale (42) an den zweiten Sägezahnmodulator (52) STM2, wobei die zweiten Befehlssignale (42) Logiksignale SU2, SD2 und W2 umfassen, wobei das Logikmodul (20) Mittel zum Bestimmen eines digitalen Signals Ddelayed umfasst, wobei das digitale Signal D um eine Dauer länger oder gleich 0,8*T0 verzögert ist, wobei
- SU1 gleich not(CLK) ist, wenn D gleich 1 und Ddelayed gleich 1 ist, und ansonsten SU1 gleich 1 ist;
- SD1 gleich dem Taktsignal CLK ist, wenn D gleich 0 ist und Ddelayed gleich 0 ist, und ansonsten SD1 gleich 0 ist;
- W1 gleich 0 oder gleich CLK ist, wenn D gleich 0 und Ddelayed gleich 0 ist, W1 gleich 1 oder gleich not(CLK) ist, wenn D gleich 1 und Ddelayed gleich 1, W1 gleich 0, wenn D gleich 0 und Ddelayed gleich 1 ist, W1 gleich 1 ist, wenn D gleich 1 und Ddelayed gleich 0 ist; wobei
- SU2 gleich not(SD1) ist;
- SD2 gleich not(SU1) ist;
- W2 gleich not(W1) ist.

10. Digitaler Isolator (10) nach Anspruch 6, **dadurch gekennzeichnet, dass** das Logikmodul (20) konfiguriert ist zum Liefern erster Befehlssignale (41) an den ersten Sägezahnmodulator (51) STM1, wobei die ersten Befehlssignale (41) logische Signale SU1, SD1 und W1 umfassen, und zum Liefern zweiter Befehlssignale (42) an den zweiten Sägezahnmodulator (52) STM2, wobei die zweiten Befehlssignale (42) Logiksignale SU2, SD2 und W2 umfassen, wobei das Logikmodul Mittel zum Bestimmen eines digitalen Signals Ddelayed umfasst, wobei das digitale Signal D um eine Dauer länger oder gleich 0,8*T0 verzögert ist, wobei
- SU1 gleich not(CLK) ist, wenn D gleich 1, Ddelayed gleich 1 und D1 gleich 1, und ansonsten SU1 gleich 1 ist;
- SD1 gleich dem Taktsignal CLK ist, wenn D gleich 0 ist, Ddelayed gleich 0 ist und D1 gleich 1, und ansonsten SD1 gleich 0 ist;
- W1 gleich 0 oder gleich CLK ist, wenn D gleich 0, Ddelayed gleich 0 und D1 gleich 1, wobei W1 gleich 1 oder gleich not(CLK) ist, wenn D gleich 1, Ddelayed gleich 1 und D1 gleich 1, wobei W1 gleich 0 ist, wenn D gleich 0 ist, Ddelayed gleich 0 und D1 gleich 0, wobei W1 gleich 1 ist, wenn D gleich 1, Ddelayed gleich 1 und D1 gleich 0; wobei
- SU2 gleich not(SD1) ist;
- SD2 gleich not(SU1) ist;
- W2 gleich not(W1) ist.

11. Digitaler Isolator nach einem der vorhergehenden Ansprüche, **dadurch gekennzeichnet, dass** der erste Sägezahnmodulator **STM1 51** umfasst
- einen ersten niederimpedanten steuerbaren Schalter LU1, der zwischen eine erste Stromversorgungsspannung V1 und den Ausgangsknoten A1 geschaltet ist, der geschlossen ist, wenn das Befehlssignal SU1 gleich 0 ist, und ansonsten offen ist;
- einen zweiten niederimpedanten steuerbaren Schalter **LD1,** der zwischen den Knoten **A1** und die erste Masse **G1** geschaltet ist, der geschlossen ist, wenn das Befehlssignal **SD1** gleich 1 ist, und ansonsten offen ist;
- einen ersten steuerbaren Schalter **MU1,** der in Reihe mit einem strombegrenzenden Dipol **ILU1** zwischen die erste Stromversorgungsspannung **V1** und den Knoten **A1** geschaltet ist, wobei der erste steuerbare Schalter **MU1** offen ist, wenn das Befehlssignal **W1** gleich 1 ist, und ansonsten geschlossen ist;
- einen zweiten steuerbaren Schalter **MD1,** der in Reihe mit einem strombegrenzenden Dipol **ILD1** zwischen den Knoten **A1** und die erste Masse **G1** geschaltet ist, wobei der zweite steuerbare Schalter geschlossen ist, wenn das Befehlssignal **W1** gleich 1 ist, und ansonsten offen ist;
- einen Kondensator **Cp1** zwischen dem Knoten **A1** und Masse **G1.**

12. Digitaler Isolator nach einem der vorhergehenden Ansprüche, **dadurch gekennzeichnet, dass** der zweite Sägezahnmodulator **STM2 52** umfasst
- einen ersten niederimpedanten steuerbaren Schalter **LU2,** der zwischen eine erste Stromversorgungsspannung **V1** und den Ausgangsknoten **A2** geschaltet ist, der geschlossen ist, wenn das Befehlssignal **SU2** gleich 0 ist, und ansonsten offen ist;
- einen zweiten niederimpedanten steuerbaren Schalter **LD2,** der zwischen den Knoten **A2** und die erste Masse **G1** geschaltet ist, der geschlossen ist, wenn das Befehlssignal **SD2** gleich 1 ist, und ansonsten offen ist;
- einen ersten steuerbaren Schalter **MU2,** der in Reihe mit einem strombegrenzenden Dipol **ILU2** zwischen die erste Stromversorgungsspannung **V1** und den Knoten **A2** geschaltet ist, wobei der erste steuerbare Schalter offen ist, wenn das Befehlssignal **W2** gleich 1 ist, und ansonsten geschlossen ist;
- einen zweiten steuerbaren Schalter **MD2,** der in Reihe mit einem strombegrenzenden Dipol **ILD2** zwischen den Knoten **A2** und die erste Masse **G1** geschaltet ist, wobei der zweite steuerbare Schalter geschlossen ist, wenn das Befehlssignal **W2** gleich 1 ist, und ansonsten offen ist;
- einen Kondensator **Cp2** zwischen dem Knoten **A2** und Masse **G1.**

13. Verfahren zum Isolieren eines digitalen Signals D unter Bezugnahme auf eine erste Masse G1 und Liefern entsprechender Signale an einen Ausgangsknoten R und einen Ausgangsknoten S unter Bezugnahme auf eine zweite Masse G2, umfassend die folgenden Schritte:
- Empfangen des digitalen Signals D und Liefern eines ersten (41) und zweiten (42) Befehlssignals, Generieren eines Taktsignals CLK mit einer Periode T0;
- Empfangen der ersten Befehlssignale (41) und Liefern eines ersten Sägezahnsignals an einen Knoten A1, wobei das erste Sägezahnsignal eine durch eine steigende Flanke des Taktsignals CLK ausgelöste schnell steigende Flanke aufweist, gefolgt von einer langsam fallenden Flanke, wenn D gleich 1, und das erste Sägezahnsignal eine durch eine steigende Flanke des Taktsignals CLK ausgelöste schnell fallende Flanke aufweist, gefolgt von einer langsam fallenden Flanke, wenn D gleich 0;
- Empfangen der zweiten Befehlssignale (42) und Liefern eines zweiten Sägezahnsignals an einen Knoten A2, wobei das zweite Sägezahnsignal eine durch eine steigende Flanke des Taktsignals CLK ausgelöste schnell fallende Flanke aufweist, gefolgt von einer langsam steigenden Flanke, wenn D gleich 1 ist, und eine durch eine steigende Flanke des Taktsignals CLK ausgelöste schnell steigende Flanke, gefolgt von einer langsam fallenden Flanke, wenn D gleich 0;
- Liefern des ersten Sägezahnsignals an einen an den Knoten A1 angeschlossen ersten Trennkondensator (61) und Erhalten eines ersten isolierten Signals an einem Knoten B1 des ersten Trennkondensators (61) ;
- Hochpassfilterung des ersten isolierten Signals, wobei ein Hochpassfilter durch den ersten Trennkondensator und einen ersten Dipol (101) Z1 gebildet wird, geschaltet zwischen den Knoten B1 und eine Vorspannungsquelle (110) unter Bezugnahme auf eine zweite Masse G2;
- Liefern des zweiten Sägezahnsignals an einen mit dem Knoten A2 verbundenen zweiten Trennkondensator (62) und Erhalten eines zweiten isolierten Signals an einem Knoten B2 des zweiten Trennkondensators (62);
- Hochpassfilterung des zweiten isolierten Signals, wobei ein Hochpassfilter durch den zweiten Trennkondensator (62) und einen zweiten Dipol (102) Z2 gebildet ist, geschaltet zwischen den Knoten B2 und die Vorspannungsquelle (110) unter Bezugnahme auf eine zweite Masse G2;
- Liefern des ersten und zweiten isolierten Signals an einen ersten Schwellwertvergleicher (121), der einen Ausgangs S produziert, der eine logische 1 ist, wenn das erste isolierte Signal das zweite isolierte Signal um einen Schwellwert Th1 übersteigt, und ansonsten eine logische 0;
- Liefern des ersten und zweiten isolierten Signals an einen zweiten Schwellwertvergleicher (122), der einen Ausgang R produziert, der eine logische 1 ist, wenn das zweite isolierte Signal das erste isolierte Signal um einen Schwellwert Th2 übersteigt, und ansonsten einen Ausgang mit einer logischen 0.

14. Verfahren nach Anspruch 13, **dadurch gekennzeichnet, dass** die Dauern der langsam steigenden Flanken und/oder der langsam fallenden Flanken an den Knoten A1 und/oder A2 jeweils mindestens das Doppelte der Dauern der entsprechenden schnell fallenden Flanken und/oder schnell ansteigenden Flanken sind.

15. Verfahren nach Anspruch 13 oder 14, **dadurch gekennzeichnet, dass** das Taktsignal CLK eine Impulsbreite aufweist, die kürzer ist als T0/3.

16. Verfahren nach einem der Ansprüche 13 bis 15, **dadurch gekennzeichnet, dass** es den Schritt des Lieferns der Signale an Ausgangsknoten R und S an entsprechende Eingänge eines SR-Zwischenspeichers umfasst.

## Revendications

1. Isolateur numérique (10) pour recevoir un signal numérique D, en référence à une première masse G1, et fournir des signaux correspondants à un noeud de sortie R et à un noeud de sortie S en référence à une deuxième masse G2, comprenant
un module logique (20) destiné à recevoir ledit signal numérique D, et destiné à fournir un premier (41) et un deuxième (42) signal de commande, ledit module logique (20) comprenant un générateur d'horloge (30) générant un signal d'horloge CLK ayant une période T0 ;
un premier modulateur de dents de scie (51) STM1 destiné à recevoir lesdits premiers signaux de commande (41), et configuré pour fournir un premier signal en dents de scie au niveau d'un nœud A1, ledit premier signal en dents de scie ayant un front montant rapide déclenché par un front montant du signal d'horloge CLK, suivi d'un front descendant lent, lorsque D est égal à 1 et ledit premier signal en dents de scie ayant un front descendant rapide déclenché par un front montant du signal d'horloge CLK, suivi d'un front montant lent, lorsque D est égal à 0 ;
un deuxième modulateur de dents de scie (52) STM2 destiné à recevoir lesdits deuxièmes signaux de commande (42), et configuré pour fournir un deuxième signal en dents de scie au niveau d'un noeud A2, ledit deuxième signal en dents de scie ayant un front descendant rapide déclenché par un front montant du signal d'horloge CLK, suivi d'un front montant lent, lorsque D est égal à 1 et un front montant rapide déclenché par un front montant du signal d'horloge CLK, suivi d'un front descendant lent, lorsque D est égal à 0 ;
un premier condensateur d'isolement (61) connecté audit noeud A1, et à un noeud B1 ;
un premier dipôle (101) Z1 connecté entre ledit noeud B1 et une source de tension de polarisation (110) en référence à une deuxième masse G2 ;
un deuxième condensateur d'isolement (62) connecté audit noeud A2, et à un noeud B2 ;
un deuxième dipôle (102) Z2 connecté entre ledit noeud B2 et ladite source de tension de polarisation (110) ;
un premier comparateur de seuil (121) ayant une première entrée connectée audit noeud B1, et une deuxième entrée connectée audit noeud B2, produisant une sortie S de 1 logique lorsque sa première entrée dépasse sa deuxième entrée d'un seuil Th1, et une sortie de 0 logique autrement ;
un deuxième comparateur de seuil (122) ayant une première entrée connectée audit noeud B2 et une deuxième entrée connectée audit noeud B1, produisant une sortie R de 1 logique lorsque sa première entrée dépasse sa deuxième entrée d'un seuil Th2, et une sortie de 0 logique autrement.

2. Isolateur numérique (10) selon la revendication 1, **caractérisé en ce que** les durées des fronts montants lents et/ou des fronts descendants lents au niveau desdits noeuds A1 et/ou A2 sont d'au moins deux fois les durées des fronts descendants rapides et/ou fronts montants rapides correspondants, respectivement.

3. Isolateur numérique (10) selon la revendication 1 ou 2, **caractérisé en ce que** ledit signal d'horloge CLK a une largeur d'impulsion plus courte que T0/3.

4. Isolateur numérique (10) selon l'une quelconque des revendications 1 à 3, **caractérisé en ce que** ledit module logique (20) comprend des moyens de désactivation du générateur d'horloge (30) à une transition du signal numérique D, et de réactivation du générateur d'horloge après un retard plus grand TD.

5. Isolateur numérique (10) selon la revendication 4, **caractérisé en ce que** ledit retard TD est plus grand que 0,5*T0, 0,6*T0, 0,7*T0, 0,8*T0 ou T0.

6. Isolateur numérique (10) selon la revendication 4 ou 5, **caractérisé en ce qu'**il est conçu pour recevoir un signal numérique D1 additionnel en référence à ladite première masse G1, **caractérisé en ce que** ledit module logique (20) comprend des moyens additionnels de désactivation du générateur d'horloge (30) lorsque le signal numérique D1 additionnel est égal à un 0 logique.

7. Isolateur numérique (10) selon l'une quelconque des revendications 1 à 3, **caractérisé en ce que** ledit module logique (20) est configuré pour fournir des premiers signaux de commande (41) audit premier modulateur de dents de scie (51) STM1, lesdits premiers signaux de commande (41) comprenant des signaux logiques SU1, SD1 et W1, et pour fournir des deuxièmes signaux de commande (42) audit deuxième modulateur de dents de scie (52) STM2, lesdits deuxième signaux de commande comprenant des signaux logiques SU2, SD2 et W2
SU1 étant égal à 1 lorsque D est égal à 0 et égal à l'inverse du signal d'horloge autrement ;
SD1 étant égal au signal d'horloge CLK, lorsque D est égal à 0 et égal à 0 autrement ;
W1 étant égal à 0 ou égal à CLK lorsque D est égal à 0, et étant égal à 1 ou égal à NON(CLK) lorsque D est égal à 1 ;
SU2 étant égal à NON(SD1) ;
SD2 étant égal à NON(SU1) ;
W2 étant égal à NON(W1).

8. Isolateur numérique (10) selon la revendication 7, **caractérisé en ce qu'**il comprend un verrou SR, lesdits signaux au niveau des noeuds de sortie R et S étant connectés à des entrées correspondantes dudit verrou SR.

9. Isolateur numérique (10) selon les revendications 4 ou 5, **caractérisé en ce que** ledit module logique (20) est configuré pour fournir des premiers signaux de commande (41) audit premier modulateur de dents de scie (51) STM1, lesdits premiers signaux de commande (41) comprenant des signaux logiques SU1, SD1 et W1, et pour fournir des deuxièmes signaux de commande (42) audit deuxième modulateur de dents de scie (52) STM2, lesdits deuxièmes signaux de commande (42) comprenant des signaux logiques SU2, SD2 et W2, ledit module logique (20) comprenant des moyens de détermination d'un signal numérique Dretardé, qui est le signal numérique D retardé d'une durée égale à ou plus longue que 0,8*T0
SU1 étant égal à NON(CLK) lorsque D est égal à 1 et Dretardé est égal à 1, et SU1 étant égal à 1 autrement ;
SD1 étant égal au signal d'horloge CLK lorsque D est égal à 0 et Dretardé est égal à 0, et SD1 étant égal à 0 autrement ;
W1 étant égal à 0 ou égal à CLK lorsque D est égal à 0 et Dretardé est égal à 0, W1 étant égal à 1 ou égal à NON(CLK) lorsque D est égal à 1 et Dretardé est égal à 1, W1 étant égal à 0 lorsque D est égal à 0 et Dretardé est égal à 1, W1 étant égal à 1 lorsque D est égal à 1 et Dretardé est égal à 0 ;
SU2 étant égal à NON(SD1) ;
SD2 étant égal à NON(SU1) ;
W2 étant égal à NON(W1).

10. Isolateur numérique (10) selon la revendication 6, **caractérisé en ce que** ledit module logique (20) est configuré pour fournir des premiers signaux de commande (41) audit premier modulateur de dents de scie (51) STM1, lesdits premiers signaux de commande (41) comprenant des signaux logiques SU1, SD1 et W1, et pour fournir des deuxièmes signaux de commande (42) audit deuxième modulateur de dents de scie (52) STM2, lesdits deuxièmes signaux de commande (42) comprenant des signaux logiques SU2, SD2 et W2, ledit module logique comprenant des moyens de détermination d'un signal numérique Dretardé, qui est le signal numérique D retardé d'une durée égale à ou plus longue que 0,8*T0 ;
SU1 étant égal à NON (CLK) lorsque D est égal à 1, Dretardé est égal à 1 et D1 est égal à 1, et SU1 étant égal à 1 autrement ;
SD1 étant égal au signal d'horloge CLK, lorsque D est égal à 0, Dretardé est égal à 0 et D1 est égal à 1, et SD1 étant égal à 0 autrement ;
W1 étant égal à 0 ou égal à CLK lorsque D est égal à 0, Dretardé est égal à 0 et D1 est égal à 1, W1 étant égal à 1 ou égal à NON (CLK) lorsque D est égal à 1, Dretardé est égal à 1 et D1 est égal à 1, W1 étant égal à 0 lorsque D est égal à 0, Dretardé est égal à 0 et D1 est égal à 0, W1 étant égal à 1 lorsque D est égal à 1, Dretardé est égal à 1 et D1 est égal à 0 ;
SU2 étant égal à NON(SD1) ;
SD2 étant égal à NON(SU1) ;
W2 étant égal à NON(W1).

11. Isolateur numérique selon l'une quelconque des revendications précédentes, **caractérisé en ce que** ledit premier modulateur de dents de scie STM1 51 comprend
un premier commutateur commandable à faible impédance LU1 connecté entre une première tension d'alimentation électrique V1 et ledit noeud de sortie A1, qui est fermé lorsque le signal de commande SU1 est égal à 0 et ouvert autrement ;
un deuxième commutateur commandable à faible impédance LD1 connecté entre ledit noeud A1 et ladite première masse G1, qui est fermé lorsque le signal de commande SD1 est égal à 1 et ouvert autrement ;
un premier commutateur commandable MU1 connecté en série avec un dipôle limiteur de courant ILU1 entre ladite première tension d'alimentation électrique V1 et ledit noeud A1, ledit premier commutateur commandable MU1 étant ouvert lorsque le signal de commande W1 est égal à 1 et fermé autrement ;
un deuxième commutateur commandable MD1 connecté en série avec un dipôle limiteur de courant ILD1, entre ledit noeud A1 et ladite première masse G1, ledit deuxième commutateur commandable étant fermé lorsque le signal de commande W1 est égal à 1 et ouvert autrement ;
un condensateur Cp1 entre ledit noeud A1 et la masse G1 .

12. Isolateur numérique selon l'une quelconque des revendications précédentes, **caractérisé en ce que** ledit deuxième modulateur de dents de scie STM2 52 comprend
un premier commutateur commandable à faible impédance LU2 connecté entre une première tension d'alimentation électrique V1 et ledit noeud de sortie A2, qui est fermé lorsque le signal de commande SU2 est égal à 0 et ouvert autrement ;
un deuxième commutateur commandable à faible impédance LD2 connecté entre ledit noeud A2 et ladite première masse G1, qui est fermé lorsque le signal de commande SD2 est égal à 1 et ouvert autrement ;
un premier commutateur commandable MU2 connecté en série avec un dipôle limiteur de courant ILU2 entre ladite première tension d'alimentation électrique V1 et ledit noeud A2, ledit premier commutateur commandable étant ouvert lorsque le signal de commande W2 est égal à 1 et fermé autrement ;
un deuxième commutateur commandable MD2 connecté en série avec un dipôle limiteur de courant ILD2, entre ledit noeud A2 et ladite première masse G1, ledit deuxième commutateur commandable étant fermé lorsque le signal de commande W2 est égal à 1 et ouvert autrement ;
un condensateur Cp2 entre ledit noeud A2 et la masse G1 .

13. Procédé d'isolement d'un signal numérique D, en référence à une première masse G1, et de fourniture de signaux correspondants à un noeud de sortie R et un noeud de sortie S en référence à une deuxième masse G2, comprenant les étapes de
réception dudit signal numérique D, et fourniture d'un premier (41) et d'un deuxième (42) signal de commande, génération d'un signal d'horloge CLK ayant une période T0 ;
réception desdits premiers signaux de commande (41), et fourniture d'un premier signal en dents de scie au niveau d'un noeud A1, ledit premier signal en dents de scie ayant un front montant rapide déclenché par un front montant du signal d'horloge CLK, suivi d'un front descendant lent, lorsque D est égal à 1 et ledit premier signal en dents de scie ayant un front descendant rapide déclenché par un front montant du signal d'horloge CLK, suivi d'un front montant lent, lorsque D est égal à 0 ;
réception desdits deuxièmes signaux de commande (42), et fourniture d'un deuxième signal en dents de scie au niveau d'un noeud A2, ledit deuxième signal en dents de scie ayant un front descendant rapide déclenché par un front montant du signal d'horloge CLK, suivi d'un front montant lent, lorsque D est égal à 1 et un front montant rapide déclenché par un front montant du signal d'horloge CLK, suivi d'un front descendant lent, lorsque D est égal à 0 ;
fourniture dudit premier signal en dents de scie à un premier condensateur d'isolement (61) connecté audit noeud A1, et obtention d'un premier signal isolé au niveau d'un noeud B1 dudit premier condensateur d'isolement (61) ;
filtrage passe-haut dudit premier signal isolé, un filtre passe-haut étant formé par ledit premier condensateur d'isolement et un premier dipôle (101) Z1 connecté entre ledit noeud B1 et une source de tension de polarisation (110) en référence à une deuxième masse G2 ;
fourniture dudit deuxième signal en dents de scie à un deuxième condensateur d'isolement (62) connecté audit noeud A2, et obtention d'un deuxième signal isolé au niveau d'un noeud B2 dudit deuxième condensateur d'isolement (62) ;
filtrage passe-haut dudit deuxième signal isolé, un filtre passe-haut étant formé par ledit deuxième condensateur d'isolement (62) et un deuxième dipôle (102) Z2 connecté entre ledit noeud B2 et ladite source de tension de polarisation (110) en référence à une deuxième masse G2 ;
fourniture desdits premier et deuxième signaux isolés à un premier comparateur de seuil (121), produisant une sortie S, qui est un 1 logique lorsque ledit premier signal isolé dépasse ledit deuxième signal isolé d'un seuil Th1, et une sortie de 0 logique autrement ;
fourniture desdits premier et deuxième signaux isolés à un deuxième comparateur de seuil (122), produisant une sortie R, qui est un 1 logique lorsque ledit deuxième signal isolé dépasse ledit premier signal isolé d'un seuil Th2, et une sortie de 0 logique autrement.

14. Procédé selon la revendication 13, **caractérisé en ce que** les durées des fronts montants lents et/ou des fronts descendants lents au niveau desdits noeuds A1 et/ou A2 sont d'au moins deux fois les durées des fronts descendants rapides et/ou fronts montants rapides correspondants, respectivement.

15. Procédé selon la revendication 13 ou 14, **caractérisé en ce que** ledit signal d'horloge CLK a une largeur d'impulsion plus courte que T0/3.

16. Procédé selon l'une quelconque des revendications 13 à 15, **caractérisé en ce qu'**il comprend l'étape de fourniture desdits signaux au niveau des noeuds de sortie R et S à des entrées correspondantes d'un verrou SR.
